# EUROPÄISCHE PATENTANMELDUNG

(11) **EP 0 862 206 A2**
(43) Veröffentlichungstag der Anmeldung: **02.09.1998**
(21) Anmeldenummer: 98102592.7
(22) Anmeldetag: 14.02.1998
(51) Int. Cl.: H01L 21/768, H01L 21/311

(54) **Ätzen von Kontaktlöchern in einer Halbleiteranordnung**

(30) Priorität: 27.02.1997 DE 19707886
(71) Anmelder: Micronas Intermetall GmbH, 79108 Freiburg (DE)
(72) Erfinder: Liebisch, Armin, 79410 Badenweiler (DE)
(74) Vertreter: Hornig, Leonore, Dr.

(57) **Zusammenfassung**

Die Erfindung betrifft ein Verfahren zum Erzeugen von Kontaktlöchern 12 in einer Halbleiteranordnung, die ein Siliziumsubstrat 1 mit aktiven Strukturen 2 aufweist, welches mit einer Isolatorschicht 9 bedeckt ist, wobei eine Ätzmaske 10 mit Öffnungen 11 zum Erzeugen von Kontaktlöchern 12 zum Kontaktieren von wenigstens einem leitfähigen Bereich 8 auf die Isolatorschicht 9 aufgebracht wird, die Kontaktlöcher 12 durch ein Plasmaätzverfahren erzeugt werden, bei dem ein zum Ätzen der Isolatorschicht 9 geeignetes und ein Trägergas enthaltendes Gasgemisch verwendet wird. Eine hohe Ätzselektivität wird dadurch erreicht, daß dem Gasgemisch Sauerstoff beigemischt wird.

## Beschreibung

Die Erfindung betrifft ein Verfahren zum Erzeugen von Kontaktlöchern in einer Halbleiteranordnung, die ein Siliziumsubstrat mit aktiven Strukturen aufweist, welches mit einer Isolatorschicht bedeckt ist, wobei eine Ätzmaske mit Öffnungen zum Erzeugen von Kontaktlöchern zum Kontaktieren von wenigstens einem leitfähigen Bereich auf die Isolatorschicht aufgebracht wird, die Kontaktlocher durch ein Plasmaätzverfahren erzeugt werden, bei welchem ein zum Ätzen der Isolatorschicht geeignetes und ein Trägergas enthaltendes Gasgemisch verwendet wird.

Ein derartiges Verfahren ist in der Halbleitertechnologie aus der Praxis bekannt.

Die Kontaktlöcher in der Isolatorschicht dienen dazu, die leitfähigen Bereiche zum Kontaktieren freizulegen. Zur Kontaktierung wird in die Kontaktlöcher ein leitfähiges Material eingebracht, welches sich mit den leitfähigen Bereichen verbindet. Die leitfähigen Bereiche sind aus einer strukturierten Schicht aus leitfähigem Material gebildet. Sie befinden sich insbesondere auf den zu kontaktierenden aktiven Strukturen und auf anzuschließenden Stellen von Leiterbahnen. Da die Halbleiteranordnungen in ihrer geometrischen Struktur sehr klein sein sollen, sind auch die leitfähigen Bereiche sehr dünn. Sie weisen relativ zu ihrer Gesamtdicke entlang des Querschnitts des kontaktierenden Bereiches starke relative Dickenschwankungen auf. Die Isolatorschicht besteht in der Regel aus einer Folge isolierender Schichten und kann planarisierende Eigenschaften für die Halbleiteranordnung haben. Somit weist die Isolatorschicht über die Halbleiteranordnung ebenfalls starke Dickenschwankungen auf. Dadurch ist es schwierig, für das Ätzverfahren einen genauen Ätzstopp so festzulegen, daß die leitfähigen Bereiche nicht überätzt werden.

Der Erfindung liegt somit die Aufgabe zugrunde, ein Verfahren zum Erzeugen von Kontaktlöchern in einer Halbleiteranordnung zu schaffen, bei dem ein Überätzen der zu kontaktierenden leitfähigen Bereiche vermieden wird.

Diese Aufgabe wird durch ein gattungsgemäßes Verfahren gelöst, bei dem dem Gasgemisch Sauerstoff beigemischt wird.

Durch den Anteil von Sauerstoff in dem Gasgemisch bei dem Plasmaätzverfahren wird die Reaktionsdynamik des Ätzvorgangs verschoben. Wenn die Isolatorschicht durchgeätzt ist, wird das Material des leitfähigen Bereichs freigelegt und durch den Sauerstoff oxidiert. Es entsteht an der Oberfläche der leitfähigen Bereiche ein nichtleitendes Material, das bei dem Plasmaätzverfahren eine niedrigere Abtragsrate aufweist als das Material des leitfähigen Bereichs und der Isolatorschicht. Während des Ätzvorgangs wird das oxidierte Material dieser Bereiche wieder abgetragen, so daß der Bereich wieder leitend wird. Es wird also der Abtragvorgang des Materials des zu kontaktierenden leitfähigen Bereichs verlangsamt, so daß der Ätzstopp bei dem Ätzen der Kontaktlöcher besser bestimmt werden kann, ohne daß die aus einer dünnen Schicht bestehenden leitfähigen Bereiche überätzt werden. Zudem wird durch das erfindungsgemäße Verfahren erreicht, daß das Entfernen der Ätzmaske, was nach dem Ausbilden der Kontaktlöcher erforderlich ist, vereinfacht wird. Dies liegt daran, daß weniger von dem leitfähigen Material der leitfähigen Bereiche abgetragen wird und somit weniger von diesem Material in dem Kontaktloch insbesondere an den Kontaktlochwänden, verbleibt. Das leitfähige Material an den Kontaktlochwänden, insbesondere im Bereich der Ätzmaske, d.h. des Photolacks, erschwert das Entfernen der Ätzmaske wesentlich.

Günstigerweise wird dem Gasgemisch so viel Sauerstoff beigefügt, daß der Anteil am Gasgemisch zwischen 1 % und 20 % beträgt. Wenn das Gasgemisch fluorierten Kohlenstoff und fluorierten Kohlenwasserstoff und als Trägergas Argon enthält, werden beim Ätzen in der Siliziumtechnologie besonders gute Ergebnisse erzielt.

Günstigerweise kann der Anteil von fluoriertem Kohlenstoff an dem Gasgemisch zwischen 8 % und 25 %, der Anteil von fluoriertem Kohlenwasserstoff an dem Gasgemisch zwischen 15 % und 45 % und der Anteil von Argon an dem Gasgemisch zwischen 25 % und 75 % betragen. Es ist vorteilhaft, wenn das Plasmaätzverfahren bei einer Frequenz von einigen 100 kH durchgeführt wird. Durch diese verhältnismäßige langsame Wechselfrequenz wird eine relativ hohe Ionenenergie der Ätzradikale erzeugt. Dadurch ist die Ätzrate relativ hoch, was aufgrund der durch das Beimischen des Sauerstoffs erzielten Selektivität des Ätzverfahrens zwischen der Isolatorschicht und den leitfähigen Bereichen zulässig ist, und zu einem relativ schnellen und damit kostengünstigeren Verfahren führt. Es ist günstig wenn das Plasmaätzverfahren bei einem Druck zwischen 150 bis 900 mT durchgeführt wird.

Es ist vorteilhaft, das Verfahren durchzuführen, wenn die leitfähigen Bereiche siliziert sind, insbesondere wenn sie mit Titan siliziert sind. Die Isolatorschicht umfaßt dabei eine in der Sitiziumtechnologie übliche Schichtenfolge, wobei bevorzugt Siliziumnitrid und Siliziumoxid verwendet wird.

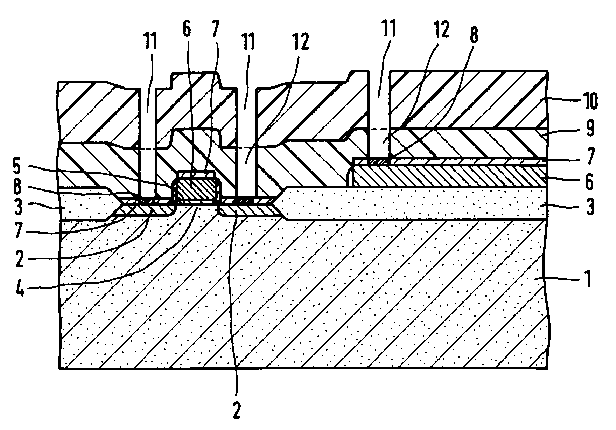

Im folgenden wird die Erfindung anhand der Zeichnung näher erläutert.

Die Figur zeigt einen Ausschnitt aus einem Querschnitt einer Halbleiteranordnung, die gemäß dem erfindungsgemäßen Verfahren bearbeitet wird.

Auf einem Siliziumsubstrat 1 sind aktive Strukturen 2 ausgebildet, die zur Isolation von einer Feldoxidschicht 3 umgeben sind. Die aktiven Strukturen 2 bilden den Source- und den Drainbereich eines MOS-Transistors. Über dem Gate-Bereich 4 des MOS-Transistors ist ein dünner Gate-Oxidfilm 5 ausgebildet. Auf den Gate-Oxidfilm 5 und einem Teilbereich der Feldoxidschicht 3 ist eine Polysiliziumschicht 6 aufgebracht. Auf die aktiven Strukturen 2 und auf die strukturierte Polysiliziumschicht 6 ist eine Kontaktschicht 7 aus einem leitfähigen Material zum Ausbilden von leitfähigen Bereichen aufgebracht. Auf diese Anordnung ist eine Isolatorschicht 9 aufgebracht, welche auch mehrere isolierende Schichten umfassen kann. Die Isolatorschicht 9 hat eine planarisierende Eigenschaft für die Oberfläche der Halbleiteranordnung. Daraus ergibt sich, daß die Isolatorschicht 9 unterschiedliche Dicke über den Querschnitt der Halbleiteranordnung aufweist. Die Isolatorschicht 9 kann aus Schichten aus Siliziumoxid und Siliziumnitrid bestehen. Auf die Isolatorschicht 9 ist eine Ätzmaske 10 aufgebracht, welche Öffnungen 11 zum Erzeugen von Kontaktlöchern zum Kontaktieren der leitfähigen Bereiche 8 aufweist.

Die Halbleiteranordnung ist in dem Zustand gezeigt, in dem gemäß dem erfindungsgemäßen Verfahren Kontaktlöcher 12 in die Isolatorschicht 9 geätzt worden sind. Dadurch sind die leitfähigen Bereiche 8, die kontaktiert werden sollen, freigelegt.

Gemäß dem erfindungsgemäßen Verfahren wird die gezeigte Halbleiteranordnung in eine Ätzvorrichtung gegeben. In der Ätzvorrichtung wird die Halbleiteranordnung einem Plasmaätzverfahren ausgesetzt. Es wird der Vorrichtung dabei ein Gasgemisch zugeführt, welches Argon als Trägergas, fluorierten Kohlenstoff, fluorierten Kohlenwasserstoff und Sauerstoff als reaktives Ätzgas enthält. Das Gasgemisch wird der Ätzvorrichtung so zugeführt, daß während des Ätzvorgangs ein Druck entsteht, der zwischen 150 mT bis 900 mT liegt. Der Anteil an Argon betragt zwischen 25 % und 75 %, der Anteil von fluoriertem Kohlenstoff zwischen 8 % und 25 %, der Anteil von fluoriertem Kohlenwasserstoff zwischen 15 % und 45% und der Anteil an Sauerstoff zwischen 1 % und 20 % des gesamten Gasflusses. Das Plasmaätzverfahren wird bei einer Frequenz von einigen 100 kH durchgeführt. Durch die relativ langsame Wechselfrequenz dieser Plasmaanregung entsteht eine relativ hohe Ionenenergie der Ätzradikale. Es wird dadurch eine hohe Ätzrate für das zu ätzende Material, d.h. insbesondere für die Isolatorschicht 9 erzielt. Der Sauerstoff bewirkt, daß das Material der leitfähigen Bereiche 8, welches bevorzugt aus mit Titan siliziertem Silizium besteht, welches aus monokristallinem oder polykristallinem Silizium gebildet sein kann, oxidiert werden. Dadurch nimmt in den leitfähigen Bereichen 8 die Abtragsrate des Materials bei dem Ätzverfahren deutlich ab. Die oxidierte Oberfläche wird aber gleichzeitig bei dem Verfahren wieder abgetragen, so daß die Oberfläche der leitfähigen Bereiche 8 wieder leitfähig wird. Durch die Verlangsamung der Ätzrate in den leitfähigen Bereichen 8 wird eine große Selektivität des Ätzverfahrens erreicht. Dies ist erforderlich, da die Kontaktschicht 7 bei den heute erforderlichen kleinen Geometrien von Halbleiteranordnungen sehr dünn ist und starken Dickenschwankungen unterliegt, und somit sehr leicht überätzt werden kann. Ferner weist die Isolatorschicht 9, die zum Planarisieren der Oberfläche des Halbleiterwafers verwendet wird, entlang des Halbleiterquerschnitts unterschiedliche Dicken auf. Man entnimmt der Figur, daß die Dicke der Isolatorschicht 9 in der gezeigten Anordnung bei den zu kontaktierenden Bereichen der aktiven Strukturen 2 auf der linken Seite der Figur erheblich größer ist als in dem zu kontaktierenden leitfähigen Bereich 8 der Leiterbahn über der Feldoxidschicht 3 auf der rechten Seite der Figur. Es wird durch das erfindungsgemäße Verfahren verhindert, daß der zu kontaktierende Bereich 8 auf der rechten Seite der Figur, der über der Feldoxidschicht 3 eingebracht ist, überätzt wird, während der leitfähige Bereich 8 auf der linken Seite der Figur zum Kontaktieren der aktiven Strukturen 2 noch freigelegt werden muß.

Nach Beenden des Plasmaätzverfahrens wird die Ätzmaske 10 entfernt. Danach wird ein zum Kontaktieren der leitfähigen Bereiche 8 geeignetes Material, beispielsweise Aluminium, Titan, etc. in die erzeugten Kontaktlöcher 12 eingebracht.

## Patentansprüche

1. Verfahren zum Erzeugen von Kontaktlöchern (12) in einer Halbleiteranordnung, die ein Siliziumsubstrat (1) mit aktiven Strukturen (2) aufweist, welches mit einer Isolatorschicht (9) bedeckt ist, wobei eine Ätzmaske (10) mit Öffnungen (11) zum Erzeugen von Kontaktlochern (12) zum Kontaktieren von wenigstens einem leitfähigen Bereich (8) auf die Isolatorschicht (9) aufgebracht wird, die Kontaktlöcher (12) durch ein Plasmaätzverfahren erzeugt werden, bei welchen ein zum Ätzen der Isolatorschicht (9) geeignetes und ein Trägergas enthaltendes Gasgemisch verwendet wird, dadurch gekennzeichnet, daß dem Gasgemisch Sauerstoff beigemischt wird.

2. Verfahren nach Anspruch 1, dadurch gekennzeichnet, daß der Anteil des Sauerstoffs an dem Gasgemisch zwischen 1 % und 20 % beträgt.

3. Verfahren nach einem der vorangehenden Ansprüche dadurch gekennzeichnet, daß das Gasgemisch fluorierten Kohlenstoff und fluorierten Kohlenwasserstoff enthält.

4. Verfahren nach einem der vorangehenden Ansprüche, dadurch gekennzeichnet, daß als Trägergas Argon verwendet wird.

5. Verfahren nach einem der vorangehenden Ansprüche, dadurch gekennzeichnet, daß der Anteil von fluoriertem Kohlenstoff an dem Gasgemisch zwischen 8 % und 25 % beträgt.

6. Verfahren nach einem der vorangehenden Ansprüche dadurch gekennzeichnet, daß der Anteil von fluoriertem Kohlenwasserstoff an dem Gasgemisch zwischen 15 % und 45 % beträgt.

7. Verfahren nach einem der vorangehenden Ansprüche, dadurch gekennzeichnet, daß der Anteil von Argon an dem Gasgemisch zwischen 25 % und 75 % beträgt.

8. Verfahren nach einem der vorangehenden Ansprüche, dadurch gekennzeichnet, daß das Plasmaätzverfahren bei einer Frequenz von einigen 100 kH durchgeführt wird.

9. Verfahren nach einem der vorangehenden Ansprüche, dadurch gekennzeichnet, daß das Plasmaätzverfahren bei einem Druck zwischen 150 bis 900 mT durchgeführt wird.

10. Verfahren nach einem der vorangehenden Ansprüche, dadurch gekennzeichnet, daß die zu kontaktierenden leitfähigen Bereiche (8) siliziert sind.

11. Verfahren nach einem der vorangehenden Ansprüche, dadurch gekennzeichnet, daß die zu kontaktierenden leitfähigen Bereiche (8) mit Titan siliziert sind.
